**Europäisches Patentamt**

**European Patent Office**

**Office européen des brevets**

(19)

(11) Veröffentlichungsnummer: **0 135 852**
**B1**

(12) # EUROPÄISCHE PATENTSCHRIFT

(45) Veröffentlichungstag der Patentschrift:
19.04.89

(21) Anmeldenummer: 84110469.8

(22) Anmeldetag: 03.09.84

(51) Int. Cl.⁴: **B 23 B 35/00**

(54) **Bohreinrichtung zum Einbringen von Löchern in Platten oder Plattenstapel.**

(30) Priorität: 20.09.83 DE 3333978

(43) Veröffentlichungstag der Anmeldung:
03.04.85 Patentblatt 85/14

(45) Bekanntmachung des Hinweises auf die Patenterteilung:
19.04.89 Patentblatt 89/16

(84) Benannte Vertragsstaaten:
CH DE FR GB IT LI SE

(56) Entgegenhaltungen:
WO-A-81/00367
WO-A-81/00368

PATENTS ABSTRACTS OF JAPAN, Band 8, Nr. 230
(M-333) 1667 , 23. Oktober 1984

(73) Patentinhaber: **Siemens Aktiengesellschaft Berlin
und München, Wittelsbacherplatz 2, D-8000
München 2 (DE)**

(72) Erfinder: **Hartmann, Gunter, Dipl.- Ing.,
Hohenwaldeckstrasse 2, D-8000 München 90 (DE)**

## Beschreibung

Die Erfindung betrifft eine Bohreinrichtung zum Einbringen von Löchern in Platten oder Plattenstapel, insbesondere in Leiterplatten oder Leiterplattenstapel, nach dem Oberbegriff des Anspruchs 1.

Leiterplatten werden zur Aufnahme der Anschlußdrähte der einzelnen Bauelemente an den jeweiligen Aufnahmepositionen mit Durchgangslöchern versehen. Das Bohren dieser Löcher erfolgt dabei meist im Stapel, d.h., mehrere Leiterplatten werden zu einem Leiterplattenstapel übereinandergeschichtet und dann gemeinsam gebohrt. Ohne zusätzliche Schutzmaßnahmen entsteht jedoch beim Anbohren ein Auswurf, der jeweils die oberste Leiterplatte unbrauchbar macht. Um dies zu vermeiden, wird dem Leiterplattenstapel als oberste Lage eine ca. 0,5 mm dicke spezielle Wegwerfplatte aus Aluminium oder Hartpapier beigelegt und am Rande mit Hilfe eines Klebebandes mit dem Leiterplattenstapel verbunden.

Soll nun das Beschicken der Bohreinrichtungen beispielsweise durch den Einsatz eines Industrieroboters mechanisiert werden, so bedeuten das Auflegen und Aufkleben einer Wegwerfplatte auf einen Leiterplattenstapel sowie das Lösen der Verklebung und das Ablegen der Wegwerfplatte zusätzliche Arbeitsgänge, die zu einem Taktzeitverlust und zu einer Beeinträchtigung der Fertigungssicherheit führen.

Der Erfindung liegt daher die Aufgabe zugrunde, eine Bohreinrichtung zum Einbringen von Löchern in Leiterplattenstapel zu schaffen, bei welcher die oberste Leiterplatte beim Anbohren mit geringem Aufwand und ohne oder zumindest ohne wesentlichen Zeitverlust geschützt wird.

Diese Aufgabe wird bei einer gattungsgemäßen Bohreinrichtung durch die kennzeichnenden Merkmale des Anspruchs 1 gelöst.

Der Schutz der obersten Platte eines Plattenstapels erfolgt also durch ein Abdeckband, das in seiner Längsrichtung verschoben und somit unabhängig von der Lochbelegung des Plattenstapels genutzt werden kann. Das Abdeckband wird dabei kurz vor dem Bohrvorgang und während des Bohrvorganges gegen den Plattenstapel gedrückt und anschließend durch Abheben des Niederhalters vom Plattenstapel gelöst. Die bei Verwendung einer Wegwerfplatte erforderlichen Arbeitsgänge des Auflegens, Aufklebens, des Lösens der Verklebung und des Ablegens der Wegwerfplatte können somit entfallen. Damit kann dann aber das Einbringen von Löchern in einen Plattenstapel mit hoher Fertigungssicherheit mechanisiert werden. Durch die von der Lochbelegung unabhängige Nutzung des Abdeckbandes und durch den Wegfall des bisher erforderlichen Klebebandes ergibt sich außerdem eine beträchtliche Materialeinsparung.

Das Abdeckband besteht vorzugsweise aus Aluminium, welches beim Anbohren einen besonders wirksamen Schutz für die oberste Platte eines Plattenstapels bietet. Das Abdeckband kann jedoch auch aus einem Kunststoff bestehen, mit welchem ähnliche Bohreigenschaften wie mit Aluminium erreicht werden können.

Gemäß einer bevorzugten Ausgestaltung der Erfindung ist das Abdeckband durch eine Vorschubeinrichtung schrittweise verschiebbar. Durch die präzise schrittweise Steuerung mit Hilfe einer Vorschubeinrichtung kann das Material des Abdeckbandes besonders wirksam ausgenutzt werden. Dabei hat es sich als zweckmäßig herausgestellt, wenn die Vorschubeinrichtung das Abdeckband bei jedem Schritt um etwa den zweifachen Betrag des Durchmessers des Bohrwerkzeugs verschiebt. Außerdem ist es vorteilhaft, die Vorschubeinrichtung in Transportrichtung des Abdeckbandes gesehen, hinter dem Niederhalter anzuordnen, da das relativ dünne Abdeckband besser gezogen als geschoben werden kann.

Eine besonders günstige und einfache Bereitstellung des Abdeckbandes wird dadurch erreicht, daß das Abdeckband von einer Vorratsrolle abspulbar ist.

Gemäß einer weiteren Ausgestaltung der Erfindung ist in Transportrichtung des Abdeckbandes gesehen hinter dem Niederhalter eine Aufspulrolle für das Abdeckband angeordnet. Mit Hilfe einer derartigen Aufspulrolle kann die Entfernung des mit Löchern versehenen und nicht mehr verwendbaren Abdeckbandes besonders einfach gestaltet werden. Im Prinzip könnte eine derartige Aufspulrolle durch eine schrittweise Steuerung auch den schrittweisen Vorschub des Abdeckbandes übernehmen. Eine bessere Materialausnutzung bei hoher Fertigungssicherheit wird jedoch durch die Verwendung einer separaten Vorschubeinrichtung erreicht, wobei dann die Aufspulrolle in Transportrichtung des Abdeckbandes gesehen, hinter der Vorschubeinrichtung angeordnet ist.

Gemäß einer weiteren bevorzugten Ausgestaltung der Erfindung sind die Vorratsrolle, der Niederhalter, die Vorschubeinrichtung und die Aufspulrolle an einer sich in Transportrichtung des Abdeckbandes erstreckenden Traverse befestigt. Hierdurch wird eine kompakte Transporteinheit für das Abdeckband gebildet. Außerdem ist es dann insbesondere im Hinblick auf einen automatisch durchzuführenden Werkzeugwechsel zweckmäßig, wenn die Traverse zur Seite hin so weit verschwenkbar ist, daß die Bohrspindel für einen Wechsel des Bohrwerkzeugs zugänglich ist.

Eine weitere vorteilhafte Ausgestaltung der Erfindung besteht darin, daß das Abdeckband an der Unterseite des Niederhalters geführt ist.

Dabei wird also die Unterseite des Niederhalters als Führungsfläche für das Abdeckband ausgenutzt. Eine besonders gute seitliche Führung mit entsprechend schmalem Abdeckband kann dann dadurch erreicht werden, daß in die Unterseite des Niederhalters eine Führungsnut für das Abdeckband eingebracht ist. Die Führung des Abdeckbandes kann außerdem dadurch weiter verbessert werden, daß der Niederhalter an der Auflaufstelle und an der Ablaufstelle des Abdeckbandes abgerundete Kanten besitzt.

Ein Ausführungsbeispiel der Erfindung ist in der Zeichnung dargestellt und wird im folgenden näher beschrieben.

Es zeigen in vereinfachter schematischer Darstellung:

Figur 1    einen Längsschnitt durch eine Bohreinrichtung zum Einbringen von Löchern in Leiterplattenstapel und

Figur 2    einen Querschnitt in Höhe der Bohrstelle durch die in Figur 1 dargestellte Bohreinrichtung.

Zum Einbringen von Löchern L in Leiterplatten Lp werden mehrere Leiterplatten Lp zu einem Leiterplattenstapel Ls übereinandergeschichtet und auf dem Bohrmaschinentisch einer Senkrechtbohrmaschine oder einer Mehrspindelbohrmaschine üblicher Bauart positioniert. Von der verwendeten Bohrmaschine ist in der Zeichnung lediglich die Bohrspindel Bs dargestellt, in welche ein Spiralbohrer als Bohrwerkzeug Bw eingespannt ist. Zu beiden Seiten der Bohrspindel Bs befinden sich die Schenkel eines in Richtung der Doppelpfeile 1 heb- und senkbaren Niederhalters Nh, dessen seitlich U-förmig hochgezogene Druckplatte Dp über in der Zeichnung nicht näher dargestellte lösbare Befestigungsmittel auswechselbar angebracht ist. Hierdurch kann die sich genau unterhalb der Bohrspindel Bs befindliche Führungsbohrung Fb der Druckplatte Dp auf den Durchmesser des jeweils verwendeten Bohrwerkzeugs Bw abgestimmt werden.

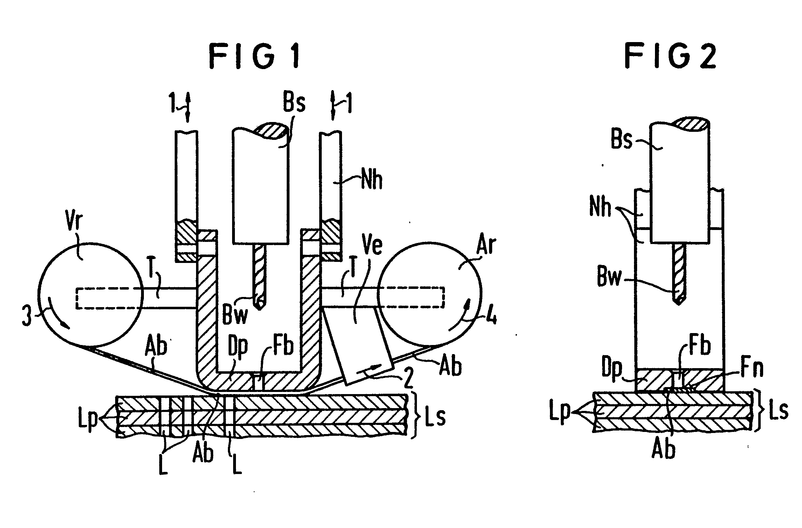

Zwei an den Befestigungsschenkeln der Druckplatte Dp angebrachte Tragarme bilden zusammen eine Traverse T, an deren gegenüberliegenden Enden eine Vorratsrolle Vr und eine Aufspulrolle Ar befestigt sind. Ausgehend von der Vorratsrolle Vr wird ein Abdeckband Ab an der Unterseite der Druckplatte Dp des Niederhalters Nh entlang der Aufspulrolle Ar zugeführt. Das Abdeckband Ab kann dabei durch eine zwischen dem Niederhalter Nh und der Aufspulrolle Ar an der Traverse T angebrachte Vorschubeinrichtung Ve schrittweise verschoben werden, wobei die Transportrichtung des Abdeckbandes Ab und die entsprechenden Drehrichtungen der Vorratsrolle Vr und der Aufspulrolle Ar durch Pfeile 2, 3 und 4 angedeutet sind. An der Auflaufstelle und an der Ablaufstelle des Abdeckbandes Ab besitzt die Druckplatte Dp des Niederhalters Nh abgerundete Kanten. Wie zusätzlich aus dem Querschnitt der Figur 2 zu ersehen ist, ist in die Unterseite der Druckplatte Dp des Niederhalters Nh eine im Querschnitt rechteckförmige Führungsnut Fn für das Abdeckband Ab eingebracht, durch welche eine Führung des Abdeckbandes Ab genau unterhalb von Bohrspindel Bs, Bohrwerkzeug Bw und Führungsbohrung Fb gewährleistet ist

Beim Einsatz der vorstehend beschriebenen Bohreinrichtung gestaltet sich der Arbeitsablauf beim Einbringen der Löcher L in einen Leiterplattenstapel Ls wie folgt:

1. Absenken des Niederhalters Nh und dadurch Andrücken des Abdeckbandes Ab auf den Leiterplattenstapel Ls.
2. Bohren eines Loches L.
3. Abheben des Niederhalters Nh und damit des Abdeckbandes Ab.
4. Weitertakten des Abdeckbandes Ab mittels der Vorschubeinrichtung Ve um eine vorgebbare Teilung und gleichzeitiges Aufspulen des Abdeckbandes Ab auf die Aufspulrolle Ar.

Nach diesem Arbeitsablauf ist die Bohrspindel Bs für einen neuen Zyklus bereit. Da das Takten bzw. Vorschieben des Abdeckbandes Ab parallel zum Neu-Positionieren des Leiterplattenstapels Ls erfolgt, wird die Maschinenzeit nicht oder nur unwesentlich verlängert.

Falls für einen automatischen Wechsel des Bohrwerkzeugs Bw erforderlich, kann der Niederhalter Nh zusammen mit der aus Vorratsrolle Vr, Vorschubeinrichtung Ve und Aufspulrolle Ar gebildeten Transporteinheit für das Abdeckband Ab seitlich unter der Bohrspindel Bs weggeschwenkt werden. Bei Verwendung von Mehrspindelbohrmaschinen ist jede Bohreinheit mit der beschriebenen Bohreinrichtung auszurüsten.

Beim Einbringen eines Loches L schützt das gegen den Leiterplattenstapel Ls gedrückte Abdeckband Ab die oberste Leiterplatte Lp und verhindert somit einen Auswurf beim Anbohren. Als Abdeckband Ab wird beispielsweise ein 0,5 mm dickes und ca. 10 mm breites Aluminiumband verwendet. Beim Weitertakten des Abdeckbandes Ab wird die Vorschubeinrichtung Ve auf eine Teilung eingestellt, welche ungefähr dem zweifachen Durchmesser des Bohrwerkzeugs Bw entspricht. Hierdurch wird eine optimale Ausnützung des Materials des Abdeckbandes Ab erreicht, bei welcher nur ca. 0,3 bis 0,5 cm² pro Bohrung benötigt werden.

**Patentansprüche**

1. Bohreinrichtung zum Einbringen von Löchern (L) in Platten oder Plattenstapel, insbesondere in Leiterplatten (Lp) oder Leiterplattenstapel (Ls), mit einer ein Bohrwerkzeug aufnehmenden Bohrspindel (Bs) und einem im Bereich der Bohrstelle auf die Platte oder den Plattenstapel aufsetzbaren Niederhalter (Nh), gekennzeichnet durch folgende Merkmale:

a) unterhalb von Bohrspindel (Bs) und Niederhalter (Nh) ist ein in seiner Längsrichtung verschiebbares Abdeckband (Ab) angeordnet,

b) das Abdeckband (Ab) ist durch den Niederhalter (Nh) gegen die Platte oder den Plattenstapel drückbar.

2. Bohreinrichtung nach Anspruch 1, dadurch gekennzeichnet, daß das Abdeckband (Ab) aus Aluminium besteht.

3. Bohreinrichtung nach Anspruch 1, dadurch gekennzeichnet, daß das Abdeckband (Ab) aus einem Kunststoff besteht.

4. Bohreinrichtung nach einem der vorhergehenden Ansprüche, dadurch gekennzeichnet, daß das Abdeckband (Ab) durch eine Vorschubeinrichtung (Ve) schrittweise verschiebbar ist.

5. Bohreinrichtung nach Anspruch 4, dadurch gekennzeichnet, daß die Vorschubeinrichtung (Ve) das Abdeckband (Ab) bei jedem Schritt um etwa den zweifachen Betrag des Durchmessers des Bohrwerkzeugs (Bw) verschiebt.

6. Bohreinrichtung nach Anspruch 4 oder 5, dadurch gekennzeichnet, daß die Vorschubeinrichtung (Ve) in Transportrichtung (2) des Abdeckbandes (Ab) gesehen hinter dem Niederhalter (Nh) angeordnet ist.

7. Bohreinrichtung nach einem der vorhergehenden Ansprüche, dadurch gekennzeichnet, daß das Abdeckband (Ab) von einer Vorratsrolle (Vr) abspulbar ist.

8. Bohreinrichtung nach einem der vorhergehenden Ansprüche, dadurch gekennzeichnet, daß in Transportrichtung (2) des Abdeckbandes (Ab) gesehen, hinter dem Niederhalter (Nh) eine Aufspulrolle (Ar) für das Abdeckband (Ab) angeordnet ist.

9. Bohreinrichtung nach den Ansprüchen 6 und 8, dadurch gekennzeichnet, daß die Aufspulrolle (Ar) in Transportrichtung (2) des Abdeckbandes (Ab) gesehen hinter der Vorschubeinrichtung (Ve) angeordnet ist.

10. Bohreinrichtung nach den Ansprüchen 7 und 9, dadurch gekennzeichnet, daß die Vorratsrolle (Vr), der Niederhalter (Nh) ) die Vorschubeinrichtung (Ve) und die Aufspulrolle (Ar) an einer sich in Transportrichtung (2) des Abdeckbandes (Ab) erstreckenden Traverse (T) befestigt sind.

11. Bohreinrichtung nach Anspruch 10, dadurch gekennzeichnet, daß die Traverse (T) zur Seite hin so weit verschwenkbar ist, daß die Bohrspindel (Bs) für einen Wechsel des Bohrwerkzeugs (Bw) zugänglich ist.

12. Bohreinrichtung nach einem der vorhergehenden Ansprüche, dadurch gekennzeichnet, daß das Abdeckband (Ab) an der Unterseite des Niederhalters (Nh) geführt ist.

13. Bohreinrichtung nach Anspruch 12, dadurch gekennzeichnet, daß in die Unterseite des Niederhalters (Nh) eine Führungsnut (Fn) für das Abdeckband (Ab) eingebracht ist.

14. Bohreinrichtung nach Anspruch 12 oder 13, dadurch gekennzeichnet, daß der Niederhalter (Nh) an der Auflaufstelle und an der Ablaufstelle des Abdeckbandes (Ab) abgerundete Kanten besitzt.

## Claims

1. Drilling apparatus for making holes (L) in boards or board stacks, particularly in printed circuit boards (Lp) or printed circuit board stacks (Ls), having a drilling spindle (Bs), which receives a drilling tool (Bw), and a work holder (Nh) placeable upon the board or board stack in the region of the drilling point, characterized by the following features:

a) a masking band (Ab) slidable in its longitudinal direction is arranged beneath the drilling spindle (Bs) and work holder (Nh),

b) the masking band (Ab) is pressable against the board or the board stack by the work holder (Nh).

2. Drilling apparatus according to Claim 1, characterized in that the masking band (Ab) is made of aluminium.

3. Drilling apparatus according to Claim 1, characterized in that the masking band (Ab) is made of a plastic.

4. Drilling apparatus according to one of the preceding Claims, characterized in that the masking band (Ab) is slidable step by step by a feed device (Ve).

5. Drilling apparatus according to Claim 4, characterized in that the feed device (Ve) slides the masking band (Ab) by approximately twice the value of the diameter of the drilling tool (Bw) at each step.

6. Drilling apparatus according to Claim 4 or 5, characterized in that the feed device (Ve) is arranged behind the work holder (Nh) as viewed in the transport direction (2) of the masking band (Ab).

7. Drilling apparatus according to on of the preceding Claims, characterized in that the masking band (Ab) is unwindable from a supply reel (Vr).

8. Drilling apparatus according to one of the preceding Claims, characterized in that a windup-reel (Ar) for the masking band (Ab) is arranged behind the work holder (Nh) as viewed in the transport direction (2) of the masking band (Ab).

9. Drilling apparatus according to Claims 6 and 8, characterized in that the wind-up reel (Ar) is arranged behind the feed device (Ve) as viewed in the transport direction (2) of the masking band (Ab).

10. Drilling apparatus according to Claims 7 and

9, characterized in that the supply reel (Vr), the work holder (Nh), the feed device (Ve) and the vind-up reel (Ar) are fastened to a cross-member (T) which extends in the transport direction (2) of the masking band (Ab).

11. Drilling apparatus according to Claim 10, characterized in that the cross-member (T) is pivotable to the side sufficiently to make the drilling spindle (Bs) accessible for an exchange of the drilling tool (Bw).

12. Drilling apparatus according to one of the preceding Claims, characterized in that the masking band (Ab) is guided on the underside of the work holder (Nh).

13. Drilling apparatus according to Claim 12, characterized in that a guide groove (Fn) for the masking band (Ab) is made in the underside of the work holder (Nh).

14. Drilling apparatus according to Claim 12 or 13, characterized in that the work holder (Nh) has rounded edges at the first contact point and at the last contact point of the masking band (Ab).

**Revendications**

1. Dispositif de perçage pour pratiquer des trous (L) dans des plaques ou des piles de plaques, en particulier des plaques à circuits imprimés ou cartes imprimées (Lp) ou des piles de cartes imprimées (Ls), comprenant une broche de perçage (Bs) contenant un outil de perçage (Bw) et un presseur (Nh) applicable contre la plaque ou la pile de plaques, caractérisé en ce que:

a) une bande de recouvrement (Ab) est disposée déplaçable dans le sens de sa longueur au-dessous de la broche de perçage (Bs) et du presseur (Nh) et
b) la bande de recouvrement (Ab) peut être pressée contre la plaque ou la pile de plaques par le presseur (Nh).

2. Dispositif selon la revendication 1, caractérisé en ce que la bande de recouvrement (Ab) est en aluminium.

3. Dispositif selon la revendication 1, caractérisé en ce que la bande de recouvrement (Ab) est en matière plastique.

4. Dispositif selon une des revendications précédentes, caractérisé en ce que la bande de recouvrement (Ab) peut être déplacée pas à pas par un dispositif d'avance (Ve).

5. Dispositif selon la revendication 4, caractérisé en ce que le dispositif d'avance (Ve) déplace la bande de recouvrement (Ab), lors de chaque pas, d'une distance correspondant à peu près au double du diamètre de l'outil de perçage (Bw).

6. Dispositif selon la revendication 4 ou 5, caractérisé en ce que le dispositif d'avance (Ve) est monté derrière le presseur (Nh) dans le sens du transport (2) de la bande de recouvrement (Ab).

7. Dispositif selon une des revendications précédentes, caractérisé en ce que la bande de recouvrement (Ab) peut être dévidée d'une bobine débitrice (Vr).

8. Dispositif selon une des revendications précédentes, caractérisé en ce qu'une bobine réceptrice (Ar) pour la bande de recouvrement (Ab) est disposée derrière le presseur (Nh) dans le sens du transport (2) de la bande de recouvrement (Ab).

9. Dispositif selon des revendications 6 et 8, caractérisé en ce que la bobine réceptrice (Ar) est disposée derrière le dispositif d'avance (Ve) dans le sens du transport (2) de la bande de recouvrement (Ab).

10. Dispositif selon les revendications 7 et 9, caractérisé en ce que la bobine débitrice (Vr), le presseur (Nh), le dispositif d'avance (Ve) et la bobine réceptrice (Ar) sont fixés à une traverse s'étendant dans le sens du transport (2) de la bande de recouvrement (Ab).

11. Dispositif selon la revendication 10, caractérisé en ce que la traverse (T) peut être écartée latéralement, par pivotement, dans une mesure suffisante pour que la broche de perçage (Bs) soit accessible en vue d'un changement de l'outil de perçage (Bw).

12. Dispositif selon une des revendications précédentes, caractérisé en ce que la bande de recouvrement (Ab) est guidée sur le côté inférieur du presseur (Nh).

13. Dispositif selon la revendication 12, caractérisé en ce qu'une rainure de guidage (Fn) pour la bande de recouvrement (Ab) est ménagée dans le côté inférieur du presseur (Nh).

14. Dispositif selon la revendication 12 ou 13, caractérisé en ce que le presseur (Nh) possède des arrêtes arrondies au point d'arrivée et au point de sortie de la bande de recouvrement (Ab).

**FIG 1**

**FIG 2**